# EUROPEAN PATENT APPLICATION

(11) **EP 4 560 706 A1**
(43) Date of publication of application: **28.05.2025**
(21) Application number: 23211777.0
(22) Date of filing: 23.11.2023
(51) Int. Cl.: H01L 27/02

(54) **ESD PROTECTION CIRCUITRY FOR A SEMICONDUCTOR CHIP, SEMICONDUCTOR CHIP, BASE STATION AND MOBILE DEVICE**

(71) Applicant: Intel Corporation, Santa Clara, CA 95052 (US)
(72) Inventor: DOMANSKI, Krzysztof, 85579 Neubiberg (DE); CASCIO, Giacomo, 9500 Villach (AT); CLARA, Martin, Santa Clara 95050 (US); GOSSNER, Harald, 85521 Riemerling (DE); ISHFAQ, Umair, 81375 München (DE); LINDHOLM, Christian, 9500 Villach (AT); SHARMA, Anand, 560043 Bangalore (IN)
(74) Representative: 2SPL Patentanwälte PartG mbB

(57) **Abstract**

ElectroStatic Discharge (ESD) protection circuitry for a semiconductor chip is provided. The ESD protection circuitry includes a first node for coupling to an I/O node of the semiconductor chip. Additionally, the ESD protection circuitry includes a first conductive path coupled to the first node via at least one first diode. The first conductive path is configured to be at a first voltage level higher than or equal to a voltage level of a first supply voltage of the semiconductor chip. Further, the ESD protection circuitry includes a second conductive path coupled to the first node via at least one second diode. The second conductive path is configured to be at a second voltage level lower than or equal to a voltage level of a second supply voltage of the semiconductor chip. The voltage level of the second supply voltage is lower than the voltage level of the first supply voltage. In addition, the ESD protection circuitry includes a second node for coupling to a ground node of the semiconductor chip or to a supply node of the semiconductor chip for providing the second supply voltage. The first conductive path is coupled to the second node via at least one capacitor and the second conductive path is coupled to the second node via at least one other capacitor.

## Description

### Field

The present disclosure relates to ElectroStatic Discharge (ESD) protection. In particular, examples of the present disclosure relate to ESD protection circuitry for a semiconductor chip, a semiconductor chip, a base station and a mobile device.

### Background

Electronic components and devices need to be safeguarded from damage or malfunction caused by ESD. For example, signal swings received by base stations for modern communication protocols such as 5G or 6G may significantly exceed supply and ground voltages provided at a semiconductor chip holding transceiver or receiver circuitry of the base station. Robust ESD protection for the transceiver or receiver circuitry is required. At the same time, the transceiver or receiver circuitry demands low loads from the ESD protection. Hence, there may be a demand for improved ESD protection.

### Brief description of the Figures

Some examples of apparatuses and/or methods will be described in the following by way of example only, and with reference to the accompanying figures, in which
Fig. 1 illustrates a first example of ESD protection circuitry;
Fig. 2 illustrates a second example of ESD protection circuitry;
Fig. 3 illustrates exemplary Charge Device Model (CDM) discharge paths in the second example of ESD protection circuitry;
Fig. 4 illustrates a third example of ESD protection circuitry;
Fig. 5 illustrates a fourth example of ESD protection circuitry;
Fig. 6 illustrates a fifth example of ESD protection circuitry;
Fig. 7 illustrates a system comprising ESD protection circuitry;
Fig. 8 illustrates an exemplary comparison of linearity vs. input power for different ESD protection circuitries;
Fig. 9 illustrates an exemplary comparison of diode transients for different reverse biasing conditions;
Fig. 10 illustrates an exemplary comparison of return loss vs. signal frequency for different reverse biasing conditions;
Fig. 11 illustrates an example of a base station; and
Fig. 12 illustrates an example of a mobile device.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

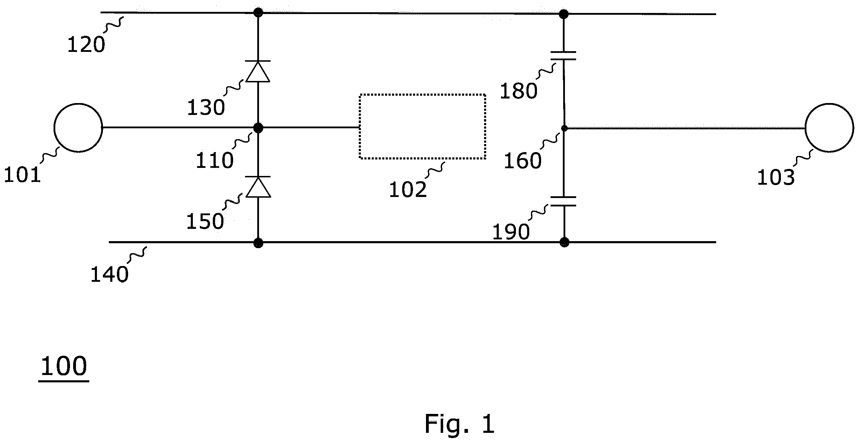

**Fig. 1** illustrates exemplary ESD protection circuitry 100 for a semiconductor chip. The ESD protection circuitry 100 comprises a first node 110 for coupling (configured to couple) to an Input/Output (I/O) node 101 of the semiconductor chip.

The I/O node 101 is a physical interface of the semiconductor chip such as a pad or a bump for receiving an input signal (e.g., a Radio Frequency, RF, input signal) from an external device and/or outputting an output signal (e.g., a RF output signal) to the external device. Processing circuitry 102 of the semiconductor chip such as a transceiver or a receiver is coupled to the I/O 101 node for processing the input signal and/or the output signal. The ESD protection circuitry 100 is provided to safeguard the processing circuitry 102 and optionally further circuitry of the semiconductor chip from damage or malfunction caused by ESD at the I/O node 101.

The ESD protection circuitry 100 comprises a first conductive path (trace) 120 coupled to the first node 110 via at least one first diode 130. In the example of Fig. 1, exactly one first diode 130 is illustrated. However, it is to be noted that in other examples, a plurality of first diodes coupled in series (in other words, stacked diodes) may be used instead to reduce the capacitance of the ESD protection circuitry 100 and increase the ESD hardness. For example, the first conductive path 120 may alternatively be coupled to the first node 110 via two, three or four first diodes 130 coupled in series. The first conductive path 120 is configured to be at a first voltage level higher than or equal to a voltage level of a first supply voltage of the semiconductor chip. For example, if the voltage level of the first supply voltage of the semiconductor chip is V_{DD}, the first voltage level may be V_{DD_virtual} ≥ V_{DD}. In other words, the voltage level of the first conductive path 120 is at least the voltage level of the positive supply voltage of the semiconductor chip for the processing circuitry 102 and optionally further circuitry of the semiconductor chip. The at least one first diode 130 is reversely biased by the first voltage level. For example, the at least one first diode 130 may be a respective p-type diode (i.e., a diode of a first conductivity type).

Further, the ESD protection circuitry 100 comprises a second conductive path 140 coupled to the first node 110 via at least one second diode 150. In the example of Fig. 1, exactly one second diode 150 is illustrated. However, it is to be noted that in other examples, a plurality of second diodes coupled in series (in other words, stacked diodes) may be used instead to reduce the capacitance of the ESD protection circuitry 100 and increase the ESD hardness. For example, the second conductive path 140 may alternatively be coupled to the first node 110 via two, three or four second diodes 150 coupled in series. The second conductive path 140 is configured to be at a second voltage level lower than or equal to a voltage level of a second supply voltage of the semiconductor chip. The voltage level of the second supply voltage is lower than the voltage level of the first supply voltage. For example, if the voltage level of the second supply voltage of the semiconductor chip is Vss, the second voltage level may be V_{SS_virtual} ≤ V_{SS}. In other words, the voltage level of the second conductive path 140 is at maximum the voltage level of the negative supply voltage of the semiconductor chip for the processing circuitry 102 and optionally further circuitry of the semiconductor chip. The at least one second diode 150 is reversely biased by the second voltage level. For example, the at least one second diode 150 may be a respective n-type diode (i.e., a diode of a second conductivity type). In other examples, the at least one first diode 130 and the at least one second diode 150 may both be p-type diodes (i.e., diodes of a first conductivity type) or n-type diodes (i.e., diodes of a second conductivity type).

The number of first diode(s) 130 and the number of second diode(s) 150 may be identical or be different from each other.

In addition, the ESD protection circuitry 100 includes a second node 160 for coupling to a ground node of the semiconductor chip or to a supply node of the semiconductor chip for providing the second supply voltage. In the example of Fig. 1, an exemplary node 103 is illustrated which is either the ground node of the semiconductor chip or the supply node of the semiconductor chip for providing the second supply voltage. The ground node is a node of the semiconductor chip for coupling to a (local) ground (potential) of the semiconductor chip 100.

The first conductive path 120 is coupled to the second node 160 via at least one (first) capacitor 180. In the example of Fig. 1, exactly one capacitor 180 is illustrated. However, it is to be noted that in other examples, a plurality of capacitors coupled in series (in other words, stacked capacitors) may be used instead to reduce the voltage drop at the respective capacitor between the first conductive path 120 and the second node 160 (e.g., to a voltage of less than 2 V at the respective capacitor as required by modern semiconductor technology nodes).

The second conductive path 140 is coupled to the second node 160 via at least one other (i.e. a second) capacitor 190. In the example of Fig. 1, exactly one other capacitor 190 is illustrated. However, it is to be noted that in other examples, a plurality of capacitors coupled in series (in other words, stacked capacitors) may be used instead to reduce the voltage drop at the respective capacitor between the second conductive path 140 and the second node 160 (e.g., to a voltage of less than 2 V at the respective capacitor as required by modern semiconductor technology nodes).

The at least one capacitor 180 and the at least one other capacitor 190 are coupled in series between the first conductive path 120 and the second conductive path 140. The second node 160 is coupled between the at least one capacitor 180 and the at least one other capacitor 190. The number of the capacitor(s) 180 and the number of the other capacitor(s) 190 may be identical like in the example of Fig. 1 or be different from each other. For example, the first conductive path 120 may alternatively be coupled to the second node 160 via two capacitors 180 (coupled in series) and the second conductive path 140 may be coupled to the second node 160 via one other capacitor 190.

The at least one capacitor 180 and the at least one other capacitor 190 may be placed in the vicinity of the I/O node 101 or alternatively be distributed over the whole chip area of the semiconductor chip.

The ESD protection circuitry 100 is low capacitance protection circuitry for over- and undervoltage tolerant I/O nodes such as the I/O node 101. The at least one first diode 130 is hooked up to a voltage level which is at least the voltage level of the positive supply voltage of the semiconductor chip (e.g., equal to or higher than the common V_{DD} level of the semiconductor chip). Analogously, the at least one second diode 150 is hooked up to a voltage level which is at maximum the voltage level of the negative supply voltage of the semiconductor chip (e.g., equal to or lower than the common Vss level of the semiconductor chip). Under normal signal conditions at the I/O node 101, this avoids forward biasing of the at least one first diode 130 and the at least one second diode 150 for large signal amplitudes with a resulting clipping of the signal. The pre-biasing of the diode junctions of the at least one first diode 130 and the at least one second diode 150 improves the linearity and lowers the effective capacitance of the diodes, which also improves the highspeed performance. Under unbiased ESD conditions, the diodes 130 and 150 go into forward bias at low voltage improving the clamping capability. In addition, the reverse biased diode junctions of the at least one first diode 130 and the at least one second diode 150 provides lower capacitance, additionally reducing the capacitive load of the I/O node 101 from the ESD protection circuitry 100.

The respective protection path to ground or the second supply voltage (e.g., global Vss of the semiconductor chip) at the second node 160 is closed by capacitors 180 and 190. The capacitors 180 and 190 enable clamping between the first conductive path 120 and the second conductive path 140. Furthermore, a respective discharge path from the I/O node 101 to the second node 160 via one of the first conductive path 120 and the second conductive path 140 is provided. As the second node 160 is tapped in-stack between the capacitors 180 and 190, all discharge paths in the CDM and the Human Body Model (HBM) are covered. Furthermore, a proper voltage required for device reliability in modern semiconductor technology nodes may be reassured. For example, transistors formed in the semiconductor chip may be Gate-All-Around Field-Effect Transistors (GAAFETs) with nanosheets (also known as RibbonFET transistors) or Complementary Field-Effect Transistors (CFETs) with nanosheets. Such modern semiconductor technology nodes have low ESD victim breakdown voltages (e.g., below 3 V) and allow only for limited supply voltages. The ESD protection circuitry 100 is adapted to the challenging requirements of these modern semiconductor technology nodes and allows robust ESD protection with low capacitive load of over- and undervoltage tolerant I/O nodes of semiconductor chips manufactured in modern semiconductor technology nodes.

The capacitances of the at least one capacitor 180 and the at least one other capacitor 190 may equal or different from each other. For example, a respective capacitance of the at least one capacitor 180 and the at least one other capacitor 190 may be more than 500 pF, 1 nF, 5 nF, 50 nF or 100 nF. In some examples, a respective capacitance of the at least one capacitor 180 may be larger than a respective capacitance of the at least one other capacitor 190. For example, a respective capacitance of the at least one capacitor 180 may be at least 100 nF and a respective capacitance of the at least one other capacitor 190 may be at least 50 nF.

The voltage levels of the first conductive path 120 and the second conductive path 140 may be generated by further circuitry of the ESD protection circuitry 100, locally on the semiconductor chip by circuitry external to the ESD protection circuitry 100, off-chip (i.e., by circuitry external to the semiconductor chip) or a combination thereof.

For example, the ESD protection circuitry 100 may optionally further comprise biasing circuitry (not illustrated in Fig. 1) coupled to the first conductive path 120 and the second conductive path 120. The biasing circuitry is configured to bias the first conductive path 120 to the first voltage level and to bias the second conductive path 140 to the second voltage level. The biasing circuitry may, e.g., comprise at least one charge pump, at least one low-dropout regulator or a combination thereof. However, it is to be noted that the biasing circuitry is not limited thereto. Other elements may be used as well.

The voltage level(s) of the first conductive path 120 and/or the second conductive path 140 may be static or dynamic. In case of dynamic voltage level(s) of the first conductive path 120 and/or the second conductive path 140, the biasing circuitry may, e.g., be configured to receive a control signal and dynamically adjust at least one of the first voltage level and the second voltage level based on the control signal. The control signal is provided from circuitry external to the ESD protection circuitry 100. Dynamically adjusting at least one of the first voltage level and the second voltage level may allow to achieve optimum high-speed performance at the I/O node 101 by, e.g., reducing the capacitance of the ESD protection circuitry 100 presented to the I/O node 101 and increasing the linearity while minimizing the needed voltage for biasing the first conductive path 120 and/or the second conductive path 140. The control signal may, e.g., be generated by the circuitry external to the ESD protection circuitry 100 in a self-calibration manner using a metric for the high-speed performance at the I/O node 101. For example, the circuitry external to the ESD protection circuitry 100 may select one or more specific voltage level setting for the first voltage level and/or the second voltage level based on a target value or characteristic for high-speed performance at the I/O node 101 such as the Singal-to-Noise Ratio (SNR) or the third-order Interception Point (IP3) and generate the control signal accordingly.

If the voltage levels of the first conductive path 120 and the second conductive path 140 are generated locally on the semiconductor chip by circuitry external to the ESD protection circuitry 100 or off-chip (i.e., by circuitry external to the semiconductor chip), the first conductive path 120 may, e.g., be coupled to (configured to couple to, couplable to) a node of the semiconductor chip for coupling the first conductive path 120 with a voltage source (not illustrated in Fig. 1) for providing the first voltage level. Similarly, the second conductive path 140 may be coupled to (configured to couple to, couplable to) a node of the semiconductor chip for coupling the second conductive path with a voltage source circuitry for providing the second voltage level. The voltage sources are external to the ESD protection circuitry 100. For example, one or both of the voltage sources may be implemented (integrated) in the semiconductor chip or be off-chip.

In some example, the conductive paths 120 and 140 may be coupled to the circuitry external to the ESD protection circuitry 100 via respective nodes providing the first/second voltage level and additionally be coupled to the biasing circuitry.

Irrespective of the source(s) of the first and second voltage levels, the ESD protection circuitry 100 may comprise a third node (not illustrated in Fig. 1) for coupling to another supply node of the semiconductor chip for providing the first supply voltage. Similarly, the ESD protection circuitry 100 may comprise a fourth node (not illustrated in Fig. 1) for coupling to the supply node of the semiconductor chip (the fourth node is separate from the second node 160). The first conductive path 120 is coupled to the third node via at least one of a resistor, an inductor or a transfer gate (not illustrated in Fig. 1). Similarly, the second conductive path 140 is coupled to the fourth node via at least one of another resistor, another inductor or another transfer gate (not illustrated in Fig. 1). The resistor and the other resistor may, e.g., exhibit a respective resistance of at least 10 kΩ, 50 kΩ or 100 kΩ. Placing the at least one of the respective resistor, inductor or transfer gate between the respective conductive path 120 or 140 and the respective one of the supply node and the other supply node allows to minimize a leakage current from the respective conductive path 120 or 140 to the respective one of the supply node and the other supply node. The respective transfer gate may be protected under ESD by coupling a respective resistor in series with the transfer gate.

The third node and the fourth node may be coupled via (by) a power clamp (ESD clamp circuit; not illustrated in Fig. 1). In other words, a power clamp is coupled between the first conductive path 120 and the second conductive path 140. A power clamp is an electronic device or circuitry that limits the voltage and/or current between the first conductive path 120 and the second conductive path 140 during an ESD event. The power clamp may come in many different varieties. In particular, the power clamp may be static or a transient power clamps. A static clamp provides a static or steady-state current and voltage response. A fixed voltage level activates the static clamp. As long as the voltage is above this level, the clamp will conduct current. For example, the static clamp may be diode based, Metal Oxide Semiconductor Field-Effect Transistor (MOSFET) based or Semiconductor Controlled Rectifier (SCR) based. On the other hand, a transient clamp takes advantage of the rapid changes in voltage and/or current that accompanies an ESD event. During this transient, an element is turned on very quickly and slowly turns off. This type of clamp conducts for a fixed time when it is triggered.

In some examples, a first power clamp (first ESD clamp circuit; not illustrated in Fig. 1) may additionally be coupled between the first conductive path 120 and the second node 160. The first power clamp is coupled in parallel to the at least one capacitor 180. Similarly, a second power clamp (second ESD clamp circuit; not illustrated in Fig. 1) may additionally be coupled between the second conductive path 140 and the second node 160. The second power clamp is coupled in parallel to the at least one other capacitor 190. The first and second power clamps allow to minimize a leakage current from the respective conductive path 120 or 140 to the second node 160 and, hence, to the ground or supply node 103 of the semiconductor chip.

According to some examples, the ESD protection circuitry 100 may additionally comprise a first flyback diode (first freewheeling diode; not illustrated in Fig. 1) coupled between the first conductive path 120 and the second node 160. The first flyback diode is coupled in parallel to the at least one capacitor 180 and the first power clamp. Similarly, a second flyback diode (second freewheeling diode; not illustrated in Fig. 1) may be coupled between the second conductive path 140 and the second node 160. The second flyback diode is coupled in parallel to the at least one other capacitor 190 and the second power clamp.

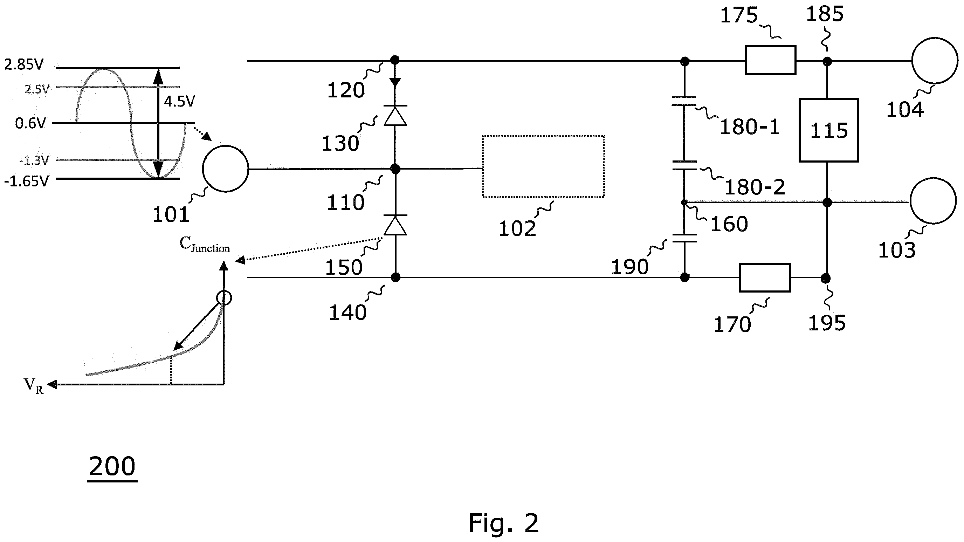

**Fig. 2** illustrates another exemplary ESD protection circuitry 200. The ESD protection circuitry 200 is based on the ESD protection circuitry 100 described above.

In comparison to the ESD protection circuitry 100, the ESD protection circuitry 200 comprises two capacitors 180-1 and 180-2 coupled in series between the first conductive path 120 and the second node 160 instead of a single capacitor. In other words, in the example of Fig. 2, the first conductive path 120 is coupled to the second node 160 via two capacitors 180-1 and 180-2 and the second conductive path 140 is coupled to the second node 160 via the other capacitor 190. Using an additional capacitor allows to reduce the voltage drop at the respective capacitor between the first conductive path 120 and the second node 160 compared to the ESD protection circuitry 100.

The respective capacitance of the capacitors 180-1 and 180-2 may be larger than the capacitance of the other capacitor 190. For example, a respective capacitance of the capacitors 180-1 and 180-2 (e.g., 100 nF each) may be at least two times the capacitance of the other capacitor 190 (e.g., 50 nF).

Furthermore, the ESD protection circuitry 200 additionally comprises a third node 185 for coupling to another supply node 104 of the semiconductor chip for providing the first supply voltage. The first conductive path 120 is coupled to the third node 185 via at least one of a resistor, an inductor or a transfer gate. In the example of Fig. 2, an exemplary element 175 is illustrated which is either the resistor, the inductor, the transfer gate or a combination thereof. The ESD protection circuitry 200 additionally comprises a fourth node 195 for coupling to the supply node 103 of the semiconductor chip (the fourth node 195 is separate from the second node 160). The second conductive path 140 is coupled to the fourth node 195 via at least one of another resistor, another inductor or another transfer gate. In the example of Fig. 2, an exemplary element 170 is illustrated which is either the other resistor, the other inductor, the other transfer gate or a combination thereof. The resistor and the other resistor may, e.g., exhibit a respective resistance of at least 10 kΩ, 50 kΩ or 100 kΩ. Placing the at least one of the respective resistor, inductor or transfer gate 170, 175 between the respective conductive path 120 or 140 and the respective one of the supply node 103 and the other supply node 104 allows to minimize a leakage current from the respective conductive path 120 or 140 to the respective one of the supply node 103 and the other supply node 104.

The third node 185 and the fourth node 195 are coupled via (by) a power clamp 115. The power clamp is further coupled between third node 185 and each of the second node 160 and the supply node 103.

Further illustrated in the lower left part of Fig. 2 is the effect of the reverse biasing of the at least one first diode 130 and the at least one second diode 150. The junction capacitance C_{Junction} of the at least one second diode 150 is plotted versus an exemplary reverse biasing voltage V_{R} as seen by the at least one second diode 150 due to the second voltage level V_{SS_virtual} of the second conductive path 140. As can be seen from Fig. 2, the polarization of the at least one second diode 150 in reverse direction causes a reduction of its junction capacitance C_{Junction} (e.g., by 15 % or more). The reduced junction capacitance of the at least one second diode 150 improves the bandwidth of the I/O node 101 for, e.g., high-speed signals (e.g., the bandwidth may be from 400 MHz to 8.4 GHz or even wider). Similarly, the polarization of the at least one first diode 130 in reverse direction causes a reduction of its junction capacitance, which in turn improves the bandwidth and the input matching (due to decreasing input return loss) of the I/O node 101.

For example, as illustrated in the upper left part of Fig. 2, the ESD protection circuitry 200 may be used if the I/O node 101 is required to operate with a signal at 0.6 V baseline with a nominal signal swing between -1.3 V to 2.5 V and a failsafe overvoltage of 4.5 V.

By setting the first voltage level of the first conductive path 120 to a voltage greater than 2.5 V, which is the maximum voltage of the signal swing under normal operation conditions, the at least one first diode 130 is prevented from conduction even in case of an overvoltage. In other words, the first conductive path 120 is configured to be at a first voltage level higher than a nominal maximum signal voltage of a signal received by the I/O node 101 (higher than a target maximum signal voltage of a signal received by the I/O node 101 under regular operation conditions). This improves signal integrity. For example, the first voltage level may be set to V_{DD_virtual} = 2.85 V. Assuming that the first supply voltage of the semiconductor chip is V_{DD} = 1.2 V, the at least one first diode 130 is reversely biased due to the first voltage level of the first conductive path 120, which leads to a reduction of the at least one first diode 130's junction capacitance (e.g., by 15 % or more in this example). The reduced junction capacitance improves the bandwidth and the input matching (due to decreasing input return loss) of the I/O node 101, in particular for high-speed signals.

Similarly, by setting the second voltage level of the second conductive path 140 to a voltage lower than -1.3 V, which is the minimum voltage of the signal swing under normal operation conditions, the at least one second diode 150 is prevented from conduction even in case of an undervoltage. In other words, the second conductive path 140 is configured to be at a second voltage level lower than a nominal minimum signal voltage of a signal received by the I/O node 101 (lower than a target minimum signal voltage of a signal received by the I/O node 101 under regular operation conditions). This improves signal integrity. For example, the second voltage level may be set to V_{SS_virtual} = -1.65 V. Assuming that the second supply voltage of the semiconductor chip is Vss = 0 V, the at least one second diode 150 is reversely biased due to the second voltage level of the second conductive path 140, which leads to a reduction of the at least one second diode 150's junction capacitance (e.g., by 15 % or more in this example). The reduced junction capacitance improves the bandwidth and the input matching (due to decreasing input return loss) of the I/O node 101, in particular for high-speed signals.

The first conductive path 120 is coupled to the first supply voltage provided by other supply node 104 by means of the element 175. The first supply voltage provides voltage bias for the first voltage level of the first conductive path 120 during, e.g., power-up. The second conductive path 140 is coupled to the second supply voltage provided by the supply node 103 by means of the element 170. The second supply voltage provides voltage bias for the second voltage level of the second conductive path 140 during, e.g., power-up.

The voltage levels of the first conductive path 120 and the second conductive path 140 may be generated by biasing circuitry as described above (not illustrated in Fig. 2). For example, the biasing circuitry may be coupled to the left-side ends of the first conductive path 120 and the second conductive path 140 in the example of Fig. 2. Additionally or alternatively, the voltage levels of the first conductive path 120 and the second conductive path 140 may be generated locally on the semiconductor chip by circuitry external to the ESD protection circuitry 100 and/or off-chip (i.e., by circuitry external to the semiconductor chip) analogously to what is described above with respect to Fig. 1. The left-side ends of the first conductive path 120 and the second conductive path 140 may be coupled accordingly to the source(s) of the first/second voltage levels.

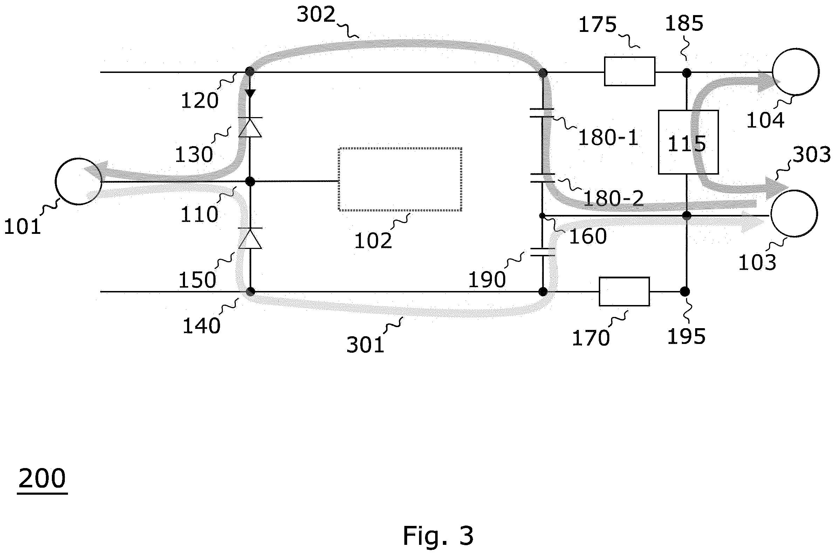

Exemplary CDM discharge paths 302, 302 and 303 in the ESD protection circuitry 200 are illustrated in **Fig. 3****.** Under CDM stress, the semiconductor chip is unpowered, all power supply are floating and CDM discharge occurs at the I/O node 101 toward a capacitively charged package and ground plane.

Under negative CDM (i.e., a positive current at the I/O node 101), the current is forced into the I/O node towards the voltage level of the second supply voltage Vss. High currents (e.g., 1 A, 2 A, 3 A, 4 A, 5 A or more) of short duration (e.g., less than 10 ns, 5 ns or 1 ns) may occur. The current is flowing via the at least one first diode 130, the first conductive path 120 and the two capacitors 180-1 and 180-2 as indicated in Fig. 3 by discharge path 302. The capacitances of the capacitors 180-1 and 180-2 may be selected (sized) to provide low-ohmic coupling of the first voltage level of the first conductive path 120 to the voltage level of the second supply voltage Vss under CDM stress.

Under positive CDM (negative current at the I/O node 101), the negative current is forced at the I/O node 101 towards the voltage level of the second supply voltage Vss. High currents (e.g., 1 A, 2 A, 3 A, 4 A, 5 A or more) of short duration (e.g., less than 10 ns, 5 ns or 1 ns) may occur. The current flow is flowing via the at least one second diode 150, the second conductive path 140 and the other capacitors 190 as indicated in Fig. 3 by discharge path 301. The capacitance of the other capacitors 190 may be selected (sized) to provide low-ohmic coupling of the second voltage level of the second conductive path 140 to the voltage level of the second supply voltage Vss under CDM stress.

In the V_{DD} or Vss CDM stress, the current flows between the voltage level of the first supply voltage V_{DD} and the voltage level of the second supply voltage Vss via the power clamp 115 as indicated by discharge path 303. A residual charge stored in the I/O node 101 can be discharged via the capacitors 180-1, 180-2 and 190 that are coupling the I/O node 101 as well as the voltage levels V_{DD_virtual} and V_{SS_virtual} of the first conductive path 120 and the second conductive path 140 to the voltage levels of the first and second supply voltages V_{DD} and Vss provided by the supply nodes 103 and 104.

The power clamp 115 between the voltage level of the first supply voltage V_{DD} and the voltage level of the second supply voltage Vss is placed to provide discharge path for CDM stress of V_{DD}. The power clamp further enables HBM protection of supply or HBM stress at I/O node 101 vs. the voltage level of the first supply voltage V_{DD} provided by the other supply node 104 or HBM stress at I/O node 101 vs. the voltage level of the second supply voltage Vss provided by the supply node 103. Additionally, the power clamp 115 allows to drive HBM currents for any stress from the I/O node 101 or the voltage level of the first supply voltage V_{DD} provided by the other supply node 104 to other power domains or signals not indicated in Fig. 3.

During HBM stress of the I/O node 101, the current flow is similar to CDM stress. The diodes 130 and 150 as well as the capacitors 180-1, 180-2 and 190 shunt the current from the I/O node 101 to the voltage level of the second supply voltage Vss provided by the supply node 103. Depending on the HBM stress combination, the current sink or source can be at the voltage level of the first supply voltage V_{DD}, the voltage level of the second supply voltage Vss or any other node in the same or a different supply domain not indicated in Fig. 3.

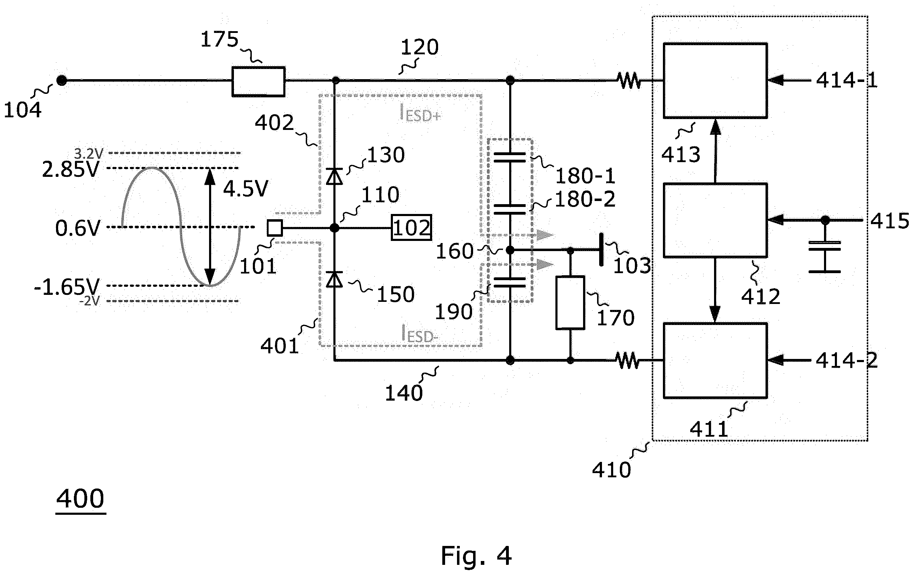

**Fig. 4** illustrates another exemplary ESD protection circuitry 400. The ESD protection circuitry 400 is based on the ESD protection circuitry 200 described above.

In comparison to the ESD protection circuitry 200, the ESD protection circuitry 400 does not comprise the power clamp 115. Furthermore, the other supply node 104 is arranged at the left side rather than the right side of the ESD protection circuitry. Accordingly, the element 175 representing the at least one of the resistor, inductor or transfer gate is arranged at the left side of the ESD protection circuitry 400.

Unlike Figs. 1 to 3, Fig. 4 explicitly shows biasing circuitry 410 for biasing the first conductive path 120 and the second conductive path 140. The biasing circuitry 410 is coupled to the first conductive path 120 and the second conductive path 140 via a respective optional resistor. As described above, the biasing circuitry 410 is configured to bias the first conductive path 120 to the first voltage level V_{DD_virtual} and to bias the second conductive path 140 to the second voltage level V_{SS_virtual}. Fig. 4 shows an exemplary design of the biasing circuitry 410. It is to be noted that the present disclosure is not limited to the specific design of the biasing circuitry 410 shown in Fig. 4.

The biasing circuitry 410 comprises a Low-DropOut (LDO) regulator 412 and two charge pumps 411 and 413. The LDO regulator 412 is configured to receive a supply voltage such as the first supply voltage V_{DD} and to convert to first supply voltage V_{DD} to pump supply voltages for the charge pumps 411 and 413. The charge pumps 411 and 413 are configured to receive the pump supply voltages and convert them to supply voltages at the first voltage level V_{DD_virtual} and the second voltage level V_{SS}_ᵥᵢᵣₜᵤₐₗ. In particular, the charge pump 411 is configured to convert the pump supply voltage from the LDO regulator 412 to a supply signal at the second voltage level V_{SS_virtual} to bias the second conductive path 140 to the second voltage level V_{SS_virtual}. Analogously, the charge pump 411 is configured to convert the pump supply voltage from the LDO regulator 412 to a supply signal at the first voltage level V_{DD_virtual} to bias the first conductive path 120 to the first voltage level V_{DD_virtual}. The charge pumps 411 and 413 are configured to convert the pump supply voltages based on a received (e.g., spread-spectrum) clock signal 414-1, 414-2 (the clock signals may be identical or different from each other).

For example, as illustrated in the upper left part of Fig. 4, the ESD protection circuitry 400 may be used if the I/O node 101 is required to operate with a signal at 0.6 V baseline with a nominal signal swing between -1.65 V to 2.85 V and a failsafe overvoltage of 4.5 V.

By setting the first voltage level V_{DD_virtual} of the first conductive path 120 by means of the biasing circuitry 410 to a voltage greater than 2.85 V, which is the maximum voltage of the signal swing under normal operation conditions, the at least one first diode 130 is prevented from conduction even in case of an overvoltage. This improves signal integrity. For example, the first voltage level may be set to V_{DD_virtual} = 3.2 V. Assuming that the first supply voltage of the semiconductor chip is V_{DD} = 1.2 V, the at least one first diode 130 is reversely biased due to the first voltage level of the first conductive path 120, which leads to a reduction of the at least one first diode 130's junction capacitance (e.g., by 15 % or more in this example). The reduced junction capacitance improves the bandwidth, the input matching (due to decreasing input return loss) and the linearity (e.g., third-order input intercept point, IP3) of the I/O node 101, in particular for high-speed signals.

Similarly, by setting the second voltage level of the second conductive path 140 by means of the biasing circuitry 410 to a voltage lower than -1.65 V, which is the minimum voltage of the signal swing under normal operation conditions, the at least one second diode 150 is prevented from conduction even in case of an undervoltage. This improves signal integrity. For example, the second voltage level may be set to V_{SS_virtual} = -2.0 V. Assuming that the second supply voltage of the semiconductor chip is Vss = 0 V, the at least one second diode 150 is reversely biased due to the second voltage level of the second conductive path 140, which leads to a reduction of the at least one second diode 150's junction capacitance (e.g., by 15 % or more in this example). The reduced junction capacitance improves the bandwidth, the input matching (due to decreasing input return loss) and the linearity (e.g., IP3) of the I/O node 101, in particular for high-speed signals.

The discharge paths 401 and 402 for positive and negative CDM ESD stress are further illustrated in Fig. 4.

For example, if the ESD protection circuitry 400 is used for a modern semiconductor technology node using GAAFETs with nanosheets (e.g., RibbonFET transistors) or CFETs with nanosheets, the chip area used for clamping with the capacitors 180-1, 180-2 and 190 may be small compared to conventional technologies. The capacitors 180-1, 180-2 and 190 may be realized (formed, implemented) as dense metal-insulator-metal capacitors placed on the backside of the chip such that they do not contribute to the consumed chip area.

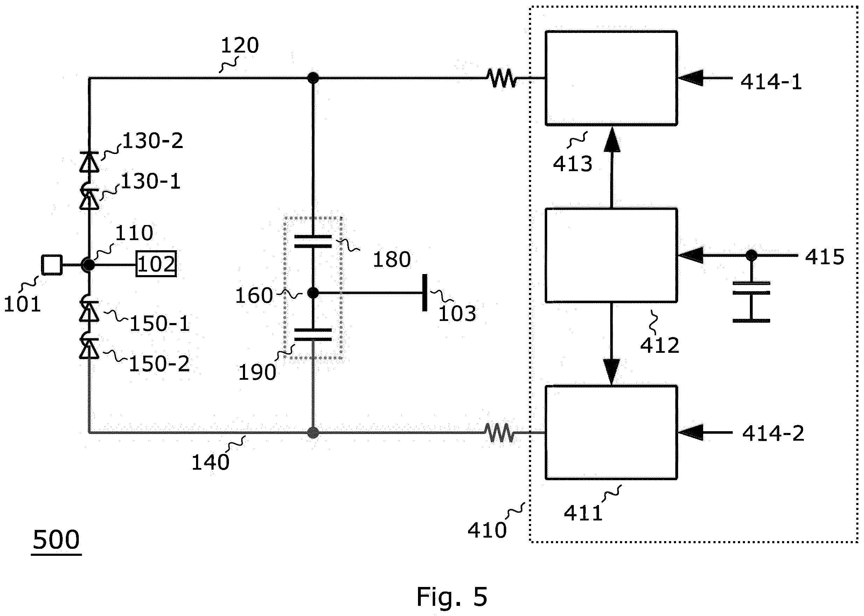

**Fig. 5** illustrates another ESD protection circuitry 500. The ESD protection circuitry 500 is a variation of the ESD protection circuitry 400 described above.

Compared to the ESD protection circuitry 400, the ESD protection circuitry 500 comprises two first diodes 130-1 and 130-2 and two second diodes 150-1 and 150-2 to increase the ESD hardness. Furthermore, the ESD protection circuitry 400 comprises only a single capacitor 180 coupled between the first conductive path 120 and the second node 160.

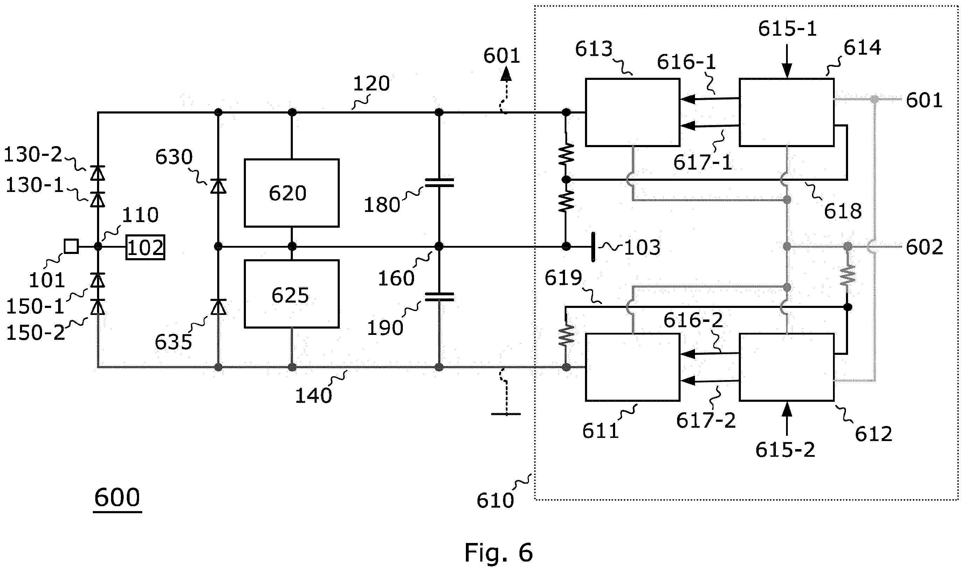

**Fig. 6** illustrates another ESD protection circuitry 600 for safeguarding the processing circuitry 102 of the semiconductor chip. Like the above examples, the ESD protection circuitry 600 comprises the first node 110 for coupling to the I/O node 101 of the semiconductor chip.

The first conductive path 120 at the first voltage level V_{DD_virtual} is coupled to the first node 110 via the two first diodes 130-1 and 130-2 analogously to what is described above for some of the other examples. Similarly, the second conductive path 140 at the second voltage level V_{SS_virtual} is coupled to the first node 110 via the two second diodes 150-1 and 150-2. The first conductive path 120 is coupled to the second node 160 via the capacitor 180 and the second conductive path 140 is coupled to the second node 160 via the other capacitor 190 analogously to what is described above for some of the other examples. For example, the capacitors 180 and 190 may be Metal-Insulator-Metal (MIM) capacitors or MIM-Metal Finger Capacitors (MIM-MFCs). The second node 160 couples to the supply node 103 providing ground or the second supply voltage Vss.

In the example of Fig. 6, a first power clamp (first ESD clamp circuit) 620 is additionally coupled between the first conductive path 120 and the second node 160. The first power clamp 620 is coupled in parallel to the capacitor 180. Similarly, a second power clamp (second ESD clamp circuit) 625 is additionally coupled between the second conductive path 140 and the second node 160. The second power clamp 625 is coupled in parallel to the other capacitor 190. The first and second power clamps 620 and 625 allow to minimize a leakage current from the respective conductive path 120 or 140 to the second node 160 and, hence, to the ground or supply node 103 of the semiconductor chip.

Further, the ESD protection circuitry 600 additionally comprises a first flyback diode (first freewheeling diode) 630 coupled between the first conductive path 120 and the second node 160. The first flyback diode 630 is coupled in parallel to the capacitor 180 and the first power clamp 620. Similarly, a second flyback diode (second freewheeling diode) 635 is coupled between the second conductive path 140 and the second node 160. The second flyback diode 635 is coupled in parallel to the other capacitor 190 and the second power clamp 625. It is to be noted that the flyback diodes 630 and 635 are optional and may be omitted according to examples of the present disclosure.

Also the above described ESD protection circuits may comprise power clamps and flyback diodes similar to the power clamps 620 and 624 and the flyback diodes 630 and 635 of the ESD protection circuitry 600.

The ESD protection circuitry 600 further comprises biasing circuitry 610 for biasing the first conductive path 120 and the second conductive path 140. The biasing circuitry 610 is coupled to the first conductive path 120 and the second conductive path 140. As described above, the biasing circuitry 610 is configured to bias the first conductive path 120 to the first voltage level V_{DD_virtual} and to bias the second conductive path 140 to the second voltage level V_{SS_virtual}. Like the biasing circuitry 410 described above, the biasing circuitry 610 comprises two charge pumps 611 and 613

The charge pumps 611 and 613 are configured to receive a respective pump supply voltage 616-1, 616-2 and convert them to supply voltages at the first voltage level V_{DD_virtual} and the second voltage level V_{SS_virtual}. In particular, the charge pump 611 is configured to convert the pump supply voltage 616-2 to a supply signal at the second voltage level V_{SS_virtual} to bias the second conductive path 140 to the second voltage level V_{SS_virtual}. Analogously, the charge pump 613 is configured to convert the pump supply voltage 616-1 to a supply signal at the first voltage level V_{DD_virtual} to bias the first conductive path 120 to the first voltage level V_{DD_virtual}. The charge pumps 611 and 613 are configured to convert the pump supply voltages based on a respective (e.g., spread-spectrum) pump clock signal 617-1, 617-2 (the clock signals may be identical or different from each other).

The pump supply voltage 616-1 and the pump clock signal 617-1 are generated by first control circuitry 614 for controlling the charge pump 613. The first control circuitry 614 is configured to receive a reference voltage signal 601 (e.g., at a voltage level of 0.5 V) and a first (e.g., spread-spectrum) clock signal 615-1. Furthermore, the first control circuitry 614 is coupled to the output of the charge pump 614 via the feedback loop 618 to receive a first feedback signal which is indicative of the first voltage level V_{DD_virtual} at the first conductive path 120. The first control circuitry 614 is configured to generate the pump supply voltage 616-1 based on a comparison of the reference voltage signal 601 and the first feedback signal. Furthermore, the first control circuitry 614 is configured to generate the pump clock signal 617-1 based on the first clock signal 615-1.

The pump supply voltage 616-2 and the pump clock signal 617-2 are generated by second control circuitry 612 for controlling the charge pump 611. The second control circuitry 612 is configured to receive the reference voltage signal 601 and a second (e.g., spread-spectrum) clock signal 615-2. Furthermore, the second control circuitry 612 is coupled to the output of the charge pump 613 via the feedback loop 619 to receive a second feedback signal which is indicative of the second voltage level V_{SS_virtual} at the second conductive path 140. The second control circuitry 612 is configured to generate the pump supply voltage 616-2 based on a comparison of the reference voltage signal 601 and the second feedback signal. Furthermore, the second control circuitry 612 is configured to generate the pump clock signal 617-2 based on the first clock signal 615-2.

The charge pumps 611 and 613 as well as the control circuitries 612 and 614 are supplied with the first supply voltage V_{DD} of the semiconductor chip as indicated by reference sign 602 in Fig. 6.

The biasing circuitry 610 uses servo loops for controlling the charge pumps 611 and 613 to increase a bandgap accuracy.

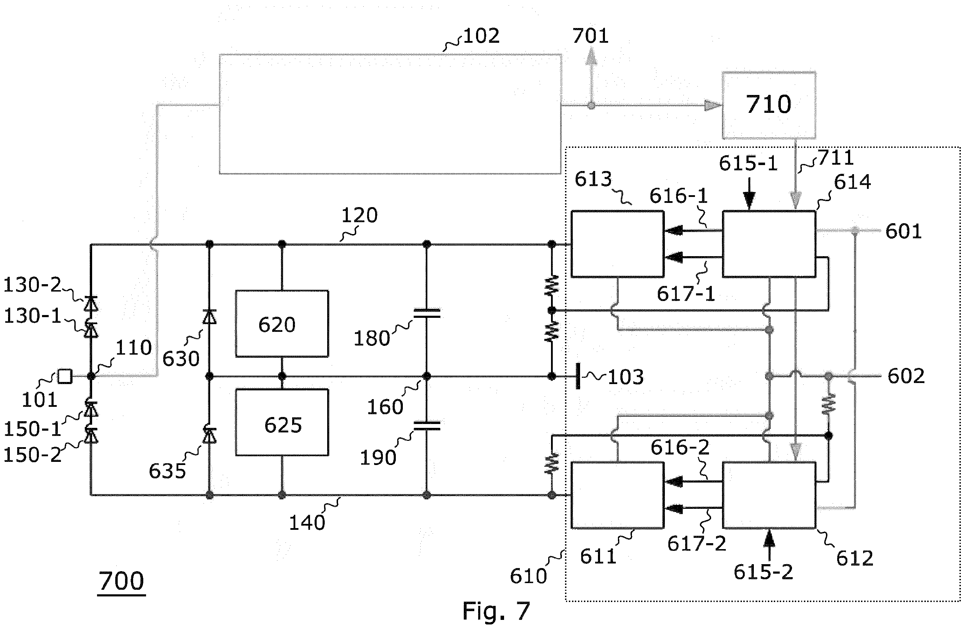

As described above, the first voltage level V_{DD_virtual} and the second voltage level V_{SS_virtual} may be adjusted dynamically. **Fig. 7** illustrates an exemplary system 700 for dynamically adjusting the first voltage level V_{DD_virtual} and the second voltage level V_{SS_virtual}. The system comprises the ESD protection circuitry 600 described above.

In the example of Fig. 7, the processing circuitry 102 is one of a RF receiver of a RF transceiver. The processing circuitry 102 receives an analog RF receive signal from the I/O node 101. The I/O node 101 is safeguarded by the ESD protection circuitry 600 as described above. The processing circuitry 102 generates a digital receive signal 701 based on the analog RF receive signal.

The digital receive signal 701 is received by control circuitry 710 external to the ESD protection circuitry 600. The control circuitry 710 may be integrated into the semiconductor chip or be off-chip. The control circuitry 710 is configured to analyze the digital receive signal 701 using a metric for the high-speed performance at the I/O node 101. For example, the control circuitry 710 may select one or more specific voltage level settings for the first voltage level and/or the second voltage level based on a target value or characteristic for high-speed performance at the I/O node 101 such as the SNR or the IP3 of the digital receive signal 701. The control circuitry 710 generates a control signal 711 indicating the selected one or more voltage level settings for the first voltage level and/or the second voltage level and output the control signal 711 to the biasing circuitry 610.

The control circuitries 612 and 614 control the charge pumps 611 and 613 based on the control signal 711 to adjust the output biasing voltages for the first and second conductive paths 120 and 140 to the one or more voltage level settings for the first voltage level and/or the second voltage level indicated by the control signal 711.

Dynamically adjusting the first voltage level and the second voltage level may allow to achieve optimum high-speed performance at the I/O node 101 by, e.g., reducing the capacitance of the ESD protection circuitry 600 presented to the I/O node 101 and increasing the linearity while minimizing the needed voltage for biasing the first conductive path 120 and/or the second conductive path 140.

The biasing circuitries 410 and 610 described above may optionally be used in the ESD protections circuitries described above with respect to Figs. 1 to 3.

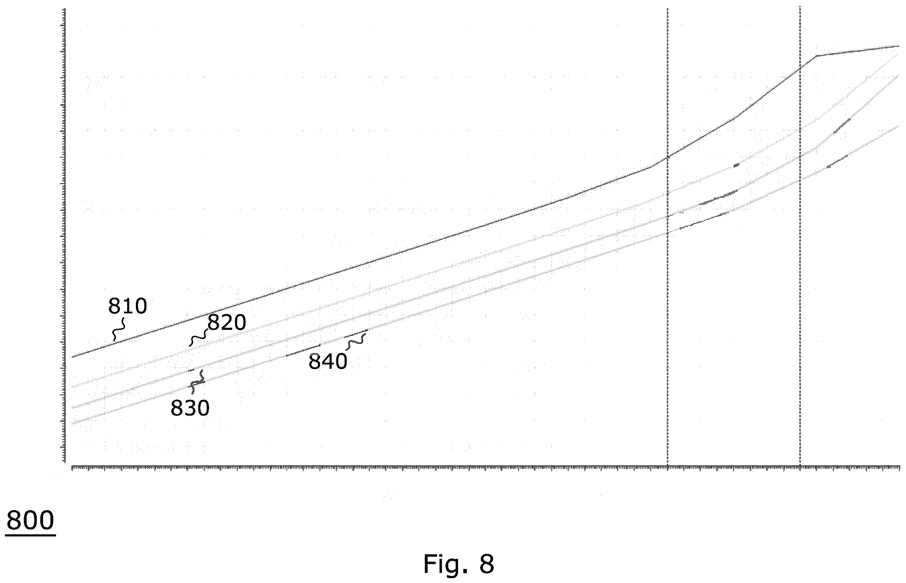

**Fig. 8** illustrates a diagram 800 highlighting an exemplary comparison of linearity vs. input power for different ESD protection circuitries coupled to an I/O node of a semiconductor chip. The abscissa of diagram 800 denotes the input power to the I/O node. The ordinate denotes the 3^{rd} order InterModulation Distortion (IMD3) at the I/O node as a measure of the linearity.

Curve 810 shows the course of the IMD3 for first ESD protection circuitry. The first ESD protection circuitry is a conventional ESD protection circuitry using a single diode between the I/O node and the respective conductive path. Curve 820 shows the course of the IMD3 for second ESD protection circuitry. The second ESD protection circuitry is a conventional ESD protection circuitry using two stacked diodes. Curve 830 shows the course of the IMD3 for third ESD protection circuitry. The third ESD protection circuitry is a conventional ESD protection circuitry using three stacked diodes.

For an ideal, linear I/On node, IMD3 vs. input power should form a straight line. As can be seen from curve 810, the linearity is maintained only within a small input power range for the first ESD protection circuitry. By increasing the number of stacked diodes, the linearity of the I/O node may be extended up to higher input powers as can be seen from curves 820 and 830.

Curve 840 shows the course of the IMD3 for ESD protection circuitry according to the present disclosure using only a single diode between the input node and the respective conductive path (e.g., one of the ESD protection circuitries illustrated in Figs. 1 to 4 or 7). As is evident from curve 840, the ESD protection circuitry according to the present disclosure provides improved linearity and a lower IMD3 over the input power spectrum. The reverse biasing of the diodes according to the proposed architectures improves the linearity and lowers the effective capacitance of the diodes, which also improves the highspeed performance.

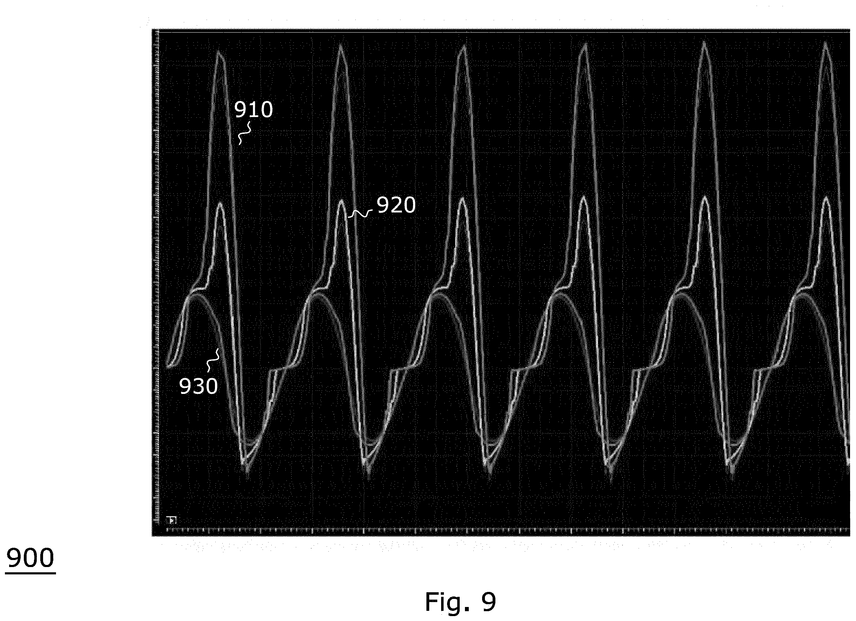

**Fig. 9** further illustrates a diagram 900 highlighting an exemplary comparison of diode transients for different reverse biasing conditions in the ESD protection circuitry 200 illustrated in Fig. 2. The abscissa of diagram 900 denotes time. The ordinate denotes the diode currents into the diodes.

The transient 910 is taken for a first voltage level V_{DD_virtual1} and a second voltage level V_{SS_virtual1} at the conductive paths. The transient 920 is taken for a first voltage level V_{DD_virtual3} and a second voltage level V_{SS_virtual} at the conductive paths. The transient 930 is taken for a first voltage level V_{DD_virtual3} and a second voltage level V_{SS_virtual3} at the conductive paths.

The first voltage levels are as follows: V_{DD_virtual1} < V_{DD_virtual2} < V_{DD_virtual3}

The second voltage levels are as follows: V_{SS_virtual3} < V_{SS_virtual2} < V_{SS_virtual1}

As can be seen from transient 910, a rectification effect occurs for small values of the first and second voltage level (e.g., if the first voltage level is not higher than the voltage level of the first supply voltage and the second voltage level is not lower than the voltage level of the second supply voltage). By increasing the reverse bias of the diodes, the rectification effect of the diodes disappears as can be seen from transients 920 and 930 (only the diode capacitive effect remains present). The harmonic components in the signal are minimized due to the higher reverse bias. The current is reduced to minimum when using higher reverse bias since the diodes remain in reverse bias during operation.

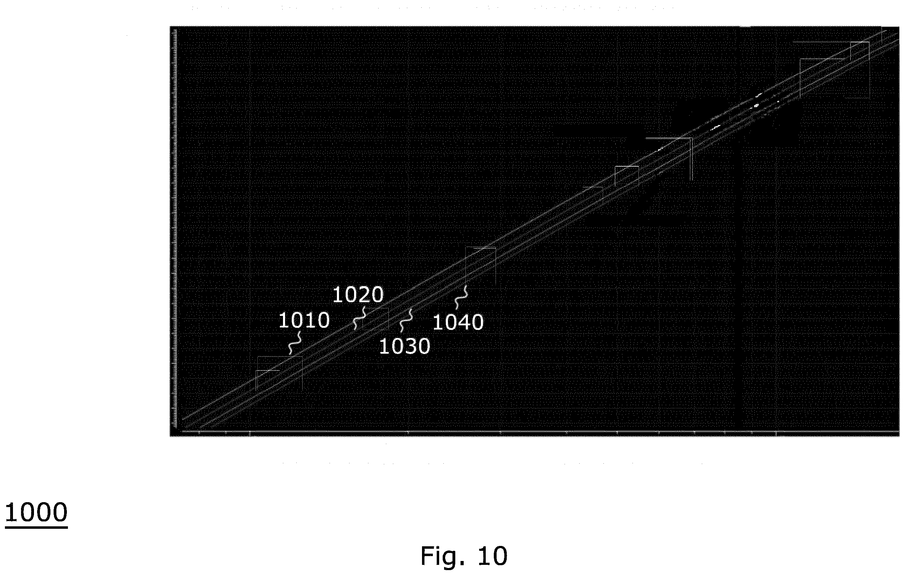

**Fig. 10** illustrates an exemplary comparison of return loss vs. signal frequency for different reverse biasing conditions in the ESD protection circuitry 200 illustrated in Fig. 2. The abscissa of diagram 1000 denotes the frequency of a signal input to the I/O node. The ordinate denotes the S11 parameter as a measure of the return loss.

The curve 1020 is taken for a first voltage level V_{DD_virtual1} and a second voltage level V_{SS_virtual1} at the conductive paths. The curve 1030 is taken for a first voltage level V_{DD_virtual3} and a second voltage level V_{SS_virtual} at the conductive paths. The curve 1040 is taken for a first voltage level V_{DD_virtual3} and a second voltage level V_{SS_virtual3} at the conductive paths.

The first voltage levels are as follows: V_{DD_virtual1} < V_{DD_virtual2} < V_{DD_virtual3}

The second voltage levels are as follows: V_{SS_virtual3} < V_{SS_virtual2} < V_{SS_virtual1}

As can be seen from transients 1020, 1030 and 1040, the S11 parameter and, hence, the return loss improves significantly with increasing reverse bias of the diodes.

As a reference, curve 1010 illustrates the course of the S11 parameter for a conventional ESD protection circuitry using a single diode between the I/O node and the respective conductive path.

ESD protection circuitry as proposed may enable cost reduction as no external matching network with inductors is needed. Furthermore, no on-chip matching network at the I/O nodes is required. Accordingly, coupling of external distortions and deterioration of signal integrity may be avoided. The capacitive load of the I/O node may be reduced (e.g., by more than 15 %) due to the reverse biased junctions of the ESD diodes, which in operation additionally allows to improve the bandwidth of the I/O node (e.g., the bandwidth may be from 400 MHz to 8.4 GHz or even wider). The signal integrity at the I/O node may be maintained even for overvoltage/undervoltage at the I/O node (e.g., for an overvoltage/undervoltage at the I/O node > 2 V for a supply voltages of 1.2 V and 0 V). Additionally, the return loss is improved significantly (e.g., by 1.5 dB at 8.4 GHz). The proposed ESD protection circuitry may be used with any semiconductor technology node (in particular nodes using GAAFETs with nanosheets such as RibbonFET transistors or nodes using CFETs with nanosheets).

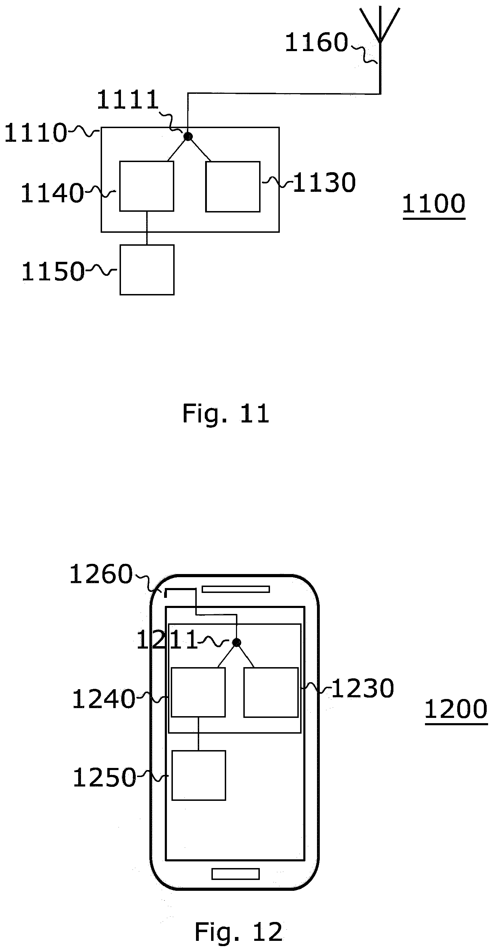

An example of an implementation using ESD protection circuitry according to one or more aspects of the architecture described above in connection with Figs. 1 to 7 or one or more examples described above in connection with Figs. 1 to 7 is illustrated in **Fig. 11.** Fig. 11 schematically illustrates an example of a radio base station 1100 (e.g. for a femtocell, a picocell, a microcell or a macrocell) comprising ESD protection circuitry 1130 as proposed.

The base station 1100 comprises at least one antenna element 1160. The antenna element 1160 is coupled to an I/O node 1111 of a semiconductor chip 1110. The semiconductor chip 1110 may be coupled to the antenna element 1160 via one or more intermediate element such as one or more of a signal line, a filter, an up-converter (mixer), a down-converter (mixer), a Power Amplifier (PA), etc.

The semiconductor chip 1110 comprises signal processing circuitry 1140 coupled to the I/O node 1111. The semiconductor chip 1110 is configured to supply the signal processing circuitry 1140 with a first supply voltage and a second supply voltage as described above. The signal processing circuitry 1140 may, e.g., comprise or be a RF transceiver. Additionally or alternatively, the signal processing circuitry 1140 may comprise or be at least one of a RF transmitter and a RF receiver.

Baseband processing circuitry (e.g., a baseband processor) 1150 is coupled to the signal processing circuitry 1140 of the semiconductor chip 1100. The baseband processing circuitry 1150 may be off-chip as illustrated in Fig. 11 or may alternatively be integrated into the semiconductor chip 1110. Depending on the type of the signal processing circuitry 1140, the baseband processing circuitry 1150 is configured to transmit digital transmit data to the signal processing circuitry 1140 and/or receive digital receive data from the signal processing circuitry 1140. For example, if the signal processing circuitry 1140 comprises or is a RF receiver, the baseband processing circuitry 1150 is configured to receive digital receive data from the signal processing circuitry 1140. If the signal processing circuitry 1140 comprises or is a RF transmitter, the baseband processing circuitry 1150 is configured to transmit digital transmit data to the signal processing circuitry 1140. In case the signal processing circuitry 1140 comprises or is a RF transceiver, the signal processing circuitry 1140 is configured to transmit digital transmit data to the signal processing circuitry 1140 and receive digital receive data from the signal processing circuitry 1140.

The baseband processing circuitry 1150 is configured to baseband process the digital receive data. Analogously, the baseband processing circuitry 1150 is configured to generate the digital transmit data by baseband processing data to be transmitted wirelessly. The RF transmitter or the RF transceiver may generate a RF transmit signal based on the digital transmit data and use the antenna element 1160 or another antenna element (not illustrated) of the base station 1100 for radiating the RF transmit signal to the environment. Analogously, the RF receiver or the RF transceiver may receive a RF receive signal received from the antenna element 1160 or another antenna element (not illustrated) of the base station 1100 and generate the digital receive data based on the RF receive signal.

The signal processing circuitry 1140 may comprise various further elements such as one or more of a Low-Noise Amplifier (LNA), a filter, an attenuator etc.

Also the ESD protection circuitry 1130 is coupled to the I/O node 1111. In particular, the first node of the ESD protection circuitry 1130 is coupled to the I/O node 1111 to safeguard the signal processing circuitry 1140 and optionally further circuitry of the semiconductor chip 1110 from damage or malfunction caused by ESD at the I/O node 1111.

To this end, a base station with improved ESD protection capabilities may be provided allowing the base station to achieve increased linearity and increased bandwidth (e.g., the bandwidth may be from 400 MHz to 8.4 GHz or even wider).

The semiconductor chip 1110 (and optionally also other elements of the base station 1100) may be manufactured in a modern semiconductor technology node using GAAFETs with nanosheets (e.g., RibbonFET transistors) or CFETs with nanosheets. In other words, transistors formed in the semiconductor chip 1100 may be GAAFETs with nanosheets or CFETs with nanosheets

The base station 1100 may comprise further elements such as, e.g., an application processor, memory, a network controller, a user interface, power management circuitry, a satellite navigation receiver, a network interface controller or power tee circuitry.

In some aspects, the application processor may include one or more Central Processing Unit (CPU) cores and one or more of cache memory, a LDO voltage regulator, interrupt controllers, serial interfaces such as Serial Peripheral Interface (SPI), Inter-Integrated Circuit (I²C) or universal programmable serial interface module, Real Time Clock (RTC), timer-counters including interval and watchdog timers, general purpose Input-Output (IO), memory card controllers such as Secure Digital (SD)/ MultiMedia Card (MMC) or similar, Universal Serial Bus (USB) interfaces, Mobile Industry Processor Interface Alliance (MIPI) interfaces and Joint Test Access Group (JTAG) test access ports.

In some aspects, the baseband processing circuitry 1150 may be implemented, for example, as a solder-down substrate including one or more integrated circuits, a single packaged integrated circuit soldered to a main circuit board or a multi-chip module containing two or more integrated circuits.

In some aspects, the memory may include one or more of volatile memory including Dynamic Random Access Memory (DRAM) and/or Synchronous Dynamic Random Access Memory (SDRAM), and Non-Volatile Memory (NVM) including high-speed electrically erasable memory (commonly referred to as Flash memory), Phase change Random Access Memory (PRAM), Magnetoresistive Random Access Memory (MRAM) and/or a three-dimensional crosspoint (3D XPoint) memory. The memory may be implemented as one or more of solder down packaged integrated circuits, socketed memory modules and plug-in memory cards.

In some aspects, the power management (integrated) circuitry may include one or more of voltage regulators, surge protectors, power alarm detection circuitry and one or more backup power sources such as a battery or capacitor. Power alarm detection circuitry may detect one or more of brown out (under-voltage) and surge (over-voltage) conditions.

In some aspects, the power tee circuitry may provide for electrical power drawn from a network cable to provide both power supply and data connectivity to the base station using a single cable.

In some aspects, the network controller may provide connectivity to a network using a standard network interface protocol such as Ethernet. Network connectivity may be provided using a physical connection which is one of electrical (commonly referred to as copper interconnect), optical or wireless.

In some aspects, the satellite navigation receiver may include circuitry to receive and decode signals transmitted by one or more navigation satellite constellations such as the Global Positioning System (GPS), GLObalnaya NAvigatSionnaya Sputnikovaya Sistema (GLONASS), Galileo and/or BeiDou. The receiver may provide data to the application processor which may include one or more of position data or time data. The application processor may use time data to synchronize operations with other radio base stations.

In some aspects, the user interface may include one or more of physical or virtual buttons, such as a reset button, one or more indicators such as Light Emitting Diodes (LEDs) and a display screen.

Another example of an implementation using ESD protection circuitry according to one or more aspects of the architecture described above in connection with Figs. 1 to 7 or one or more examples described above in connection with Figs. 1 to 7 is illustrated in **Fig. 12.** Fig. 12 schematically illustrates an example of a mobile device 1200 (e.g. mobile phone, smartphone, tablet-computer, or laptop) comprising ESD protection circuitry 1230 as proposed.

The mobile device 1200 comprises at least one antenna element 1260. The antenna element 1260 is coupled to an I/O node 1211 of a semiconductor chip 1210. The semiconductor chip 1210 may be coupled to the antenna element 1260 via one or more intermediate element such as one or more of a signal line, a filter, an up-converter (mixer), a down-converter (mixer), a PA, etc.

The semiconductor chip 1210 comprises signal processing circuitry 1240 coupled to the I/O node 1211. The semiconductor chip 1210 is configured to supply the signal processing circuitry 1240 with a first supply voltage and a second supply voltage as described above. The signal processing circuitry 1240 may, e.g., comprise or be a RF transceiver. Additionally or alternatively, the signal processing circuitry 1240 may comprise or be at least one of a RF transmitter and a RF receiver.

Baseband processing circuitry (e.g., a baseband processor) 1250 is coupled to the signal processing circuitry 1240 of the semiconductor chip 1200. The baseband processing circuitry 1250 may be off-chip as illustrated in Fig. 12 or may alternatively be integrated into the semiconductor chip 1210. Depending on the type of the signal processing circuitry 1240, the baseband processing circuitry 1250 is configured to transmit digital transmit data to the signal processing circuitry 1240 and/or receive digital receive data from the signal processing circuitry 1240. For example, if the signal processing circuitry 1240 comprises or is a RF receiver, the baseband processing circuitry 1250 is configured to receive digital receive data from the signal processing circuitry 1240. If the signal processing circuitry 1240 comprises or is a RF transmitter, the baseband processing circuitry 1250 is configured to transmit digital transmit data to the signal processing circuitry 1240. In case the signal processing circuitry 1240 comprises or is a RF transceiver, the signal processing circuitry 1240 is configured to transmit digital transmit data to the signal processing circuitry 1240 and receive digital receive data from the signal processing circuitry 1240.

The baseband processing circuitry 1250 is configured to baseband process the digital receive data. Analogously, the baseband processing circuitry 1250 is configured to generate the digital transmit data by baseband processing data to be transmitted wirelessly. The RF transmitter or the RF transceiver may generate a RF transmit signal based on the digital transmit data and use the antenna element 1260 or another antenna element (not illustrated) of the mobile device 1200 for radiating the RF transmit signal to the environment. Analogously, the RF receiver or the RF transceiver may receive a RF receive signal received from the antenna element 1260 or another antenna element (not illustrated) of the mobile device 1200 and generate the digital receive data based on the RF receive signal.

The signal processing circuitry 1240 may comprise various further elements such as one or more of a LNA, a filter, an attenuator etc.

Also the ESD protection circuitry 1230 is coupled to the I/O node 1211. In particular, the first node of the ESD protection circuitry 1230 is coupled to the I/O node 1211 to safeguard the signal processing circuitry 1240 and optionally further circuitry of the semiconductor chip 1210 from damage or malfunction caused by ESD at the I/O node 1211.

To this end, a mobile device with improved ESD protection capabilities may be provided allowing the mobile device to achieve increased linearity and increased bandwidth (e.g., the bandwidth may be from 400 MHz to 8.4 GHz or even wider).

The semiconductor chip 1210 (and optionally also other elements of the mobile device 1200) may be manufactured in a modern semiconductor technology node using GAAFETs with nanosheets (e.g., RibbonFET transistors) or CFETs with nanosheets. In other words, transistors formed in the semiconductor chip 1200 may be GAAFETs with nanosheets or CFETs with nanosheets

The mobile device 1200 may comprise further elements such as, e.g., an application processor, memory, a connectivity module, a Near Field Communication (NFC) controller, an audio driver, a camera driver, a touch screen, a display driver, sensors, removable memory, a power management integrated circuit or a smart battery.

In some aspects, the application processor may include, for example, one or more CPU cores and one or more of cache memory, LDO regulators, interrupt controllers, serial interfaces such as SPI, I²C or universal programmable serial interface module, RTC, timer-counters including interval and watchdog timers, general purpose input-output (IO), memory card controllers such as SD/MMC or similar, USB interfaces, MIPI interfaces and JTAG test access ports.

In some aspects, the baseband processing circuitry 1250 may be implemented, for example, as a solder-down substrate including one or more integrated circuits, a single packaged integrated circuit soldered to a main circuit board, and/or a multi-chip module containing two or more integrated circuits.

The wireless communication circuits using ESD protection according to the proposed architecture or one or more of the examples described above may be configured to operate according to one of the 3rd Generation Partnership Project (3GPP)-standardized mobile communication networks or systems. The mobile or wireless communication system may correspond to, for example, a 5^{th} Generation New Radio (5GNR), a Long-Term Evolution (LTE), an LTE-Advanced (LTE-A), High Speed Packet Access (HSPA), a Universal Mobile Telecommunication System (UMTS) or a UMTS Terrestrial Radio Access Network (UTRAN), an evolved-UTRAN (e-UTRAN), a Global System for Mobile communication (GSM), an Enhanced Data rates for GSM Evolution (EDGE) network, or a GSM/EDGE Radio Access Network (GERAN). Alternatively, the wireless communication circuits may be configured to operate according to mobile communication networks with different standards, for example, a Worldwide Inter-operability for Microwave Access (WIMAX) network IEEE 802.16 or Wireless Local Area Network (WLAN) IEEE 802.11, generally an Orthogonal Frequency Division Multiple Access (OFDMA) network, a Time Division Multiple Access (TDMA) network, a Code Division Multiple Access (CDMA) network, a Wideband-CDMA (WCD-MA) network, a Frequency Division Multiple Access (FDMA) network, a Spatial Division Multiple Access (SDMA) network, etc.

The ESD protection circuitry according to the proposed architecture is described above in the context of wireless communication circuitry. However, it is to be noted that the ESD protection circuitry is not restricted to wireless communication applications. The ESD protection circuitry according to the proposed architecture may be used to safeguard any kind of processing circuitry in a semiconductor chip from damage or malfunction caused by ESD at an I/O node of the semiconductor chip (the ESD protection circuitry and the processing circuitry being coupled to the I/O node of the semiconductor chip).

The examples described herein may be summarized as follows:
An example (e.g., example 1) relates to ElectroStatic Discharge, ESD, protection circuitry for a semiconductor chip, the ESD protection circuitry comprising a first node for coupling to an I/O node of the semiconductor chip, a first conductive path coupled to the first node via at least one first diode, wherein the first conductive path is configured to be at a first voltage level higher than or equal to a voltage level of a first supply voltage of the semiconductor chip, a second conductive path coupled to the first node via at least one second diode, wherein the second conductive path is configured to be at a second voltage level lower than or equal to a voltage level of a second supply voltage of the semiconductor chip, the voltage level of the second supply voltage being lower than the voltage level of the first supply voltage, and a second node for coupling to a ground node of the semiconductor chip or to a supply node of the semiconductor chip for providing the second supply voltage, wherein the first conductive path is coupled to the second node via at least one capacitor and the second conductive path is coupled to the second node via at least one other capacitor.

Another example (e.g., example 2) relates to a previous example (e.g., example 1) or to any other example, further comprising that the first conductive path is coupled to the first node via two first diodes coupled in series, and wherein the second conductive path is coupled to the first node via two second diodes coupled in series.

Another example (e.g., example 3) relates to a previous example (e.g., one of the examples 1 or 2) or to any other example, further comprising biasing circuitry coupled to the first conductive path and the second conductive path, wherein the biasing circuitry is configured to bias the first conductive path to the first voltage level and bias the second conductive path to the second voltage level.

Another example (e.g., example 4) relates to a previous example (e.g., example 3) or to any other example, further comprising that the biasing circuitry comprises at least one charge pump, at least one low-dropout regulator or a combination thereof.

Another example (e.g., example 5) relates to a previous example (e.g., one of the examples 3 or 4) or to any other example, further comprising that the biasing circuitry is configured to receive a control signal, and dynamically adjust at least one of the first voltage level and the second voltage level based on the control signal.

Another example (e.g., example 6) relates to a previous example (e.g., one of the examples 1 to 5) or to any other example, further comprising that the first conductive path is coupled to a node of the semiconductor chip for coupling the first conductive path with a voltage source external to the ESD protection circuitry for providing the first voltage level, wherein the second conductive path is coupled to a node of the semiconductor chip for coupling the second conductive path with a voltage source external to the ESD protection circuitry for providing the second voltage level.

Another example (e.g., example 7) relates to a previous example (e.g., one of the examples 1 to 6) or to any other example, further comprising a third node for coupling to another supply node of the semiconductor chip for providing the first supply voltage, and a fourth node for coupling to the supply node of the semiconductor chip, wherein the first conductive path is coupled to the third node via a resistor, an inductor or a transfer gate, and wherein the second conductive path is coupled to the fourth node via another resistor, another inductor or another transfer gate.

Another example (e.g., example 8) relates to a previous example (e.g., example 7) or to any other example, further comprising that the resistor and the other resistor exhibit a respective resistance of at least 10 kΩ.

Another example (e.g., example 9) relates to a previous example (e.g., one of the examples 7 or 8) or to any other example, further comprising that the third node and the fourth node are coupled via a power clamp.

Another example (e.g., example 10) relates to a previous example (e.g., one of the examples 1 to 9) or to any other example, further comprising that the at least one first diode is reversely biased by the first voltage level, wherein the at least one second diode is reversely biased by the second voltage level.

Another example (e.g., example 11) relates to a previous example (e.g., one of the examples 1 to 10) or to any other example, further comprising that the first conductive path is coupled to the second node via two capacitors, and wherein the second conductive path is coupled to the second node via one other capacitor.

Another example (e.g., example 12) relates to a previous example (e.g., one of the examples 1 to 11) or to any other example, further comprising that the at least one capacitor and the at least one other capacitor are coupled in series, wherein the second node is coupled between the at least one capacitor and the at least one other capacitor.

Another example (e.g., example 13) relates to a previous example (e.g., one of the examples 1 to 12) or to any other example, further comprising that a respective capacitance of the at least one capacitor and the at least one other capacitor is more than 500 pF.

Another example (e.g., example 14) relates to a previous example (e.g., one of the examples 1 to 13) or to any other example, further comprising that a respective capacitance of the at least one capacitor is larger than a respective capacitance of the at least one other capacitor. Another example (e.g., example 15) relates to a previous example (e.g., one of the examples 1 to 14) or to any other example, further comprising a first power clamp coupled between the first conductive path and the second node, wherein the first power clamp is coupled in parallel to the at least one capacitor, and a second power clamp coupled between the second conductive path and the second node, wherein the second power clamp is coupled in parallel to the at least one other capacitor.

Another example (e.g., example 16) relates to a previous example (e.g., example 15) or to any other example, further comprising a first flyback diode coupled between the first conductive path and the second node, wherein the first flyback diode is coupled in parallel to the at least one capacitor and the first power clamp, and a second flyback diode coupled between the second conductive path and the second node, wherein the second flyback diode is coupled in parallel to the at least one other capacitor and the second power clamp.

An example (e.g., example 17) relates to a semiconductor chip, comprising an I/O node, an ElectroStatic Discharge, ESD, protection circuitry according to a previous example (e.g., one of the examples 1 to 16) or to any other example, wherein the first node of the ESD protection circuitry is coupled to the I/O node, and signal processing circuitry coupled to the I/O node, wherein the semiconductor chip is configured to supply the signal processing circuitry with the first supply voltage and the second supply voltage.

Another example (e.g., example 18) relates to a previous example (e.g., example 17) or to any other example, further comprising that the signal processing circuitry comprises at least one of a radio frequency transceiver, a radio frequency transmitter and a radio frequency receiver.

Another example (e.g., example 19) relates to a previous example (e.g., one of the examples 17 or 18) or to any other example, further comprising that transistors formed in the semiconductor chip are Gate-All-Around Field-Effect Transistors, GAAFETs, with nanosheets or Complementary Field-Effect Transistors, CFETs, with nanosheets.

An example (e.g., example 20) relates to a base station, comprising a semiconductor chip according to a previous example (e.g., one of the examples 17 to 19) or to any other example, and at least one antenna coupled to the I/O node of the semiconductor chip.

Another example (e.g., example 21) relates to a previous example (e.g., example 20) or to any other example, further comprising baseband processing circuitry coupled to the signal processing circuitry of the semiconductor chip, wherein the baseband processing circuitry is configured to transmit digital transmit data to the signal processing circuitry and/or receive digital receive data from the signal processing circuitry.

An example (e.g., example 22) relates to a mobile device, comprising a semiconductor chip according to a previous example (e.g., one of the examples 17 to 19) or to any other example, and at least one antenna coupled to the I/O node of the semiconductor chip.

Another example (e.g., example 23) relates to a previous example (e.g., example 22) or to any other example, further comprising baseband processing circuitry coupled to the signal processing circuitry of the semiconductor chip, wherein the baseband processing circuitry is configured to transmit digital transmit data to the signal processing circuitry and/or receive digital receive data from the signal processing circuitry.

The aspects and features described in relation to a particular one of the previous examples may also be combined with one or more of the further examples to replace an identical or similar feature of that further example or to additionally introduce the features into the further example.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several substeps, -functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. ElectroStatic Discharge, ESD, protection circuitry (100) for a semiconductor chip, the ESD protection circuitry (100) comprising:
a first node (110) for coupling to an I/O node (101) of the semiconductor chip;
a first conductive path (120) coupled to the first node (110) via at least one first diode (130), wherein the first conductive path (120) is configured to be at a first voltage level higher than or equal to a voltage level of a first supply voltage of the semiconductor chip;
a second conductive path (140) coupled to the first node (110) via at least one second diode (150), wherein the second conductive path (140) is configured to be at a second voltage level lower than or equal to a voltage level of a second supply voltage of the semiconductor chip, the voltage level of the second supply voltage being lower than the voltage level of the first supply voltage; and
a second node (160) for coupling to a ground node (103) of the semiconductor chip or to a supply node (103) of the semiconductor chip for providing the second supply voltage,
wherein the first conductive path (120) is coupled to the second node (160) via at least one capacitor (180) and the second conductive path (140) is coupled to the second node (160) via at least one other capacitor (190).

2. The ESD protection circuitry (100) of claim 1, wherein the first conductive path (120) is coupled to the first node (110) via two first diodes (130-1, 130-2) coupled in series, and wherein the second conductive path (140) is coupled to the first node (110) via two second diodes (150-1, 150-2) coupled in series.

3. The ESD protection circuitry (100) of claim 1 or claim 2, further comprising biasing circuitry (410, 610) coupled to the first conductive path (120) and the second conductive path (140), wherein the biasing circuitry (410, 610) is configured to:
bias the first conductive path (120) to the first voltage level; and
bias the second conductive path (140) to the second voltage level.

4. The ESD protection circuitry (100) of claim 3, wherein the biasing circuitry (410, 610) comprises at least one charge pump, at least one low-dropout regulator or a combination thereof.

5. The ESD protection circuitry (100) of claim 3 or claim 4, wherein the biasing circuitry (610) is configured to:
receive a control signal (711); and
dynamically adjust at least one of the first voltage level and the second voltage level based on the control signal (711).

6. The ESD protection circuitry (100) of any one of claims 1 to 5, wherein the first conductive path (120) is configured to couple to a node of the semiconductor chip for coupling the first conductive path (120) with a voltage source external to the ESD protection circuitry for providing the first voltage level, and wherein the second conductive path (140) is configured to couple to a node of the semiconductor chip for coupling the second conductive path (140) with a voltage source external to the ESD protection circuitry for providing the second voltage level.

7. The ESD protection circuitry (100) of any one of claims 1 to 6, further comprising:
a third node (185) for coupling to another supply node (104) of the semiconductor chip for providing the first supply voltage; and
a fourth node (195) for coupling to the supply node (103) of the semiconductor chip,
wherein the first conductive path (120) is coupled to the third node (185) via a resistor, an inductor or a transfer gate, and
wherein the second conductive path (140) is coupled to the fourth node (195) via another resistor, another inductor or another transfer gate.

8. The ESD protection circuitry (100) of claim 7, wherein the third node (185) and the fourth node (195) are coupled via a power clamp (115).

9. The ESD protection circuitry (100) of any one of claims 1 to 8, wherein the at least one first diode (130) is reversely biased by the first voltage level, and wherein the at least one second diode (150) is reversely biased by the second voltage level.

10. The ESD protection circuitry (100) of any one of claims 1 to 9, wherein the first conductive path (120) is coupled to the second node (160) via two capacitors (180-1, 180-2), and wherein the second conductive path (140) is coupled to the second node (160) via one other capacitor (190).

11. The ESD protection circuitry (100) of any one of claims 1 to 10, wherein the at least one capacitor (180) and the at least one other capacitor (190) are coupled in series, and wherein the second node (160) is coupled between the at least one capacitor (180) and the at least one other capacitor (190).

12. The ESD protection circuitry (100) of any one of claims 1 to 11, wherein a respective capacitance of the at least one capacitor (180) is larger than a respective capacitance of the at least one other capacitor (190).

13. The ESD protection circuitry (100) of any one of claims 1 to 12, further comprising:
a first power clamp (620) coupled between the first conductive path (120) and the second node (160), wherein the first power clamp is coupled in parallel to the at least one capacitor (180); and
a second power clamp (625) coupled between the second conductive path (140) and the second node (160), wherein the second power clamp is coupled in parallel to the at least one other capacitor (190).

14. The ESD protection circuitry (100) of claim 13, further comprising:
a first flyback diode (630) coupled between the first conductive path (120) and the second node (160), wherein the first flyback diode (630) is coupled in parallel to the at least one capacitor (180) and the first power clamp (620); and
a second flyback diode (635) coupled between the second conductive path (140) and the second node (160), wherein the second flyback diode (635) is coupled in parallel to the at least one other capacitor (190) and the second power clamp (625).

15. A semiconductor chip (1110, 1210), comprising:
an I/O node (1111, 1211);
an ElectroStatic Discharge, ESD, protection circuitry (1130, 1230) according to any one of claims 1 to 14, wherein the first node of the ESD protection circuitry (1130, 1230) is coupled to the I/O node (1111, 1211); and
signal processing circuitry (1140, 1240) coupled to the I/O node (1111, 1211), wherein the semiconductor chip (1110, 1210) is configured to supply the signal processing circuitry (1140, 1240) with the first supply voltage and the second supply voltage.
